# FASCICULE DE BREVET EUROPEEN

(11) **EP 3 482 493 B1**
(45) Date de publication et mention de la délivrance du brevet: **04.10.2023**
(21) Numéro de dépôt: 17754731.2
(22) Date de dépôt: 04.07.2017
(51) Int. Cl.: H03F 1/02, H03F 3/189, H03F 3/24

(54) **SYSTEME DE SUIVI DE LA PUISSANCE CRETE D'UN SIGNAL DE TELECOMMUNICATION ET PROCEDE DE CALCUL DE VALEUR DE CRETE ET DE SELECTION DE TENSION D'ALIMENTATION ASSOCIE**
SYSTEM ZUR ÜBERWACHUNG DER SPITZENLEISTUNG EINES TELEKOMMUNIKATIONSSIGNALS UND VERFAHREN ZUR BERECHNUNG DES SPITZENWERTES UND ZUR AUSWAHL DER ZUGEHÖRIGEN VERSORGUNGSSPANNUNG
SYSTEM FOR MONITORING THE PEAK POWER OF A TELECOMMUNICATION SIGNAL AND METHOD FOR CALCULATING THE PEAK VALUE AND FOR SELECTING THE ASSOCIATED SUPPLY VOLTAGE

(30) Priorité: 06.07.2016 FR 1656453
(43) Date de publication de la demande: 15.05.2019
(73) Titulaire: Wupatec, 87000 Limoges (FR)
(72) Inventeur: GATARD, Emmanuel, 87350 PANAZOL (FR); LACHAUD, Pierre, 87240 AMBAZAC (FR)
(74) Mandataire: Cabinet Chaillot
(86) Numéro de dépôt international: PCT/FR2017/051819
(87) Numéro de publication internationale: WO 2018/007752

(56) Documents cités:
- US-A1- 2004 017 251
- US-A1- 2011 316 623
- US-A1- 2015 194 933
- US-A1- 2015 270 806
- US-A1- 2017 264 244

## Description

La présente invention concerne le domaine de l'amplification de puissance radiofréquence (RF), et porte en particulier sur un système de suivi de la puissance crête d'un signal de télécommunication à émettre pour une amplification de puissance RF à l'aide d'une fenêtre temporelle glissante et sur un procédé de calcul de valeur de crête et de sélection de tension d'alimentation associé.

Les amplificateurs de puissance dans les émetteurs radiofréquences (RF), pour les communications sans fil, utilisent des modulations complexes à haute efficacité spectrale. Ces modulations présentent des facteurs de crête importants, c'est-à-dire le rapport entre la puissance crête et la puissance moyenne du signal (« Peak to Average Power Ratio (PAPR) » en anglais). Les amplificateurs de puissance RF ou hyperfréquences conventionnels qui sont alimentés par une tension d'alimentation continue fournissent un rendement maximal uniquement lorsqu'ils travaillent à la compression, c'est-à-dire à la puissance crête du signal à émettre. La plupart du temps, l'amplificateur de puissance RF fournit une puissance bien inférieure à sa puissance maximale et donc le rendement de l'amplificateur de puissance RF est, dans ces conditions, inférieur à son rendement maximal.

La technique de suivi d'enveloppe est une technique d'alimentation pour améliorer le rendement des amplificateurs de puissance RF. Elle remplace l'alimentation continue de l'amplificateur de puissance RF par une alimentation dynamique qui suit l'amplitude du signal RF à émettre. La technique de suivi d'enveloppe permet d'ajuster dynamiquement la tension d'alimentation de l'amplificateur de puissance RF afin que celui-ci fonctionne toujours en compression et donc à son rendement maximal, quel que soit le niveau de puissance de l'enveloppe du signal à émettre.

L'augmentation constante des débits de communication sans fil nécessite l'utilisation de modulations à efficacité spectrale élevée et PAPR élevé telles que le multiplexage par répartition orthogonale de la fréquence (OFDM). La technique de suivi d'enveloppe permet, pour les formats de modulations modernes, d'améliorer significativement le rendement des amplificateurs de puissance RF tout en répondant aux exigences en termes de linéarité.

Dans le cas d'un amplificateur de puissance RF utilisant la technique de suivi d'enveloppe, la tension d'alimentation est, par définition, constamment réajustée afin de s'assurer que l'amplificateur de puissance RF fonctionne toujours à la compression et donc à son rendement maximal quel que soit le niveau de puissance souhaité à l'émission.

Une technique particulière de suivi d'enveloppe s'appuie sur la génération d'un signal de polarisation de drain de l'amplificateur de puissance RF de type multi-niveaux (ou discret), le fonctionnement s'apparentant alors à celui d'un amplificateur audio en classe G. L'amplification en classe G est simple à mettre en œuvre mais ne permet pas d'améliorer le rendement de l'amplificateur de puissance RF autant qu'avec la technique de suivi d'enveloppe continue.

La génération d'un signal de commande de polarisation à plusieurs niveaux discrets est assurée par la sélection d'une tension d'alimentation parmi une pluralité d'alimentations. Cette technique particulière de suivi d'enveloppe présente l'avantage de supporter de larges bandes passantes tout en maintenant un rendement élevé sans avoir recours à un amplificateur linéaire additionnel, en classe A ou AB, au sein du convertisseur continu-continu.

Pour un signal de suivi d'enveloppe exploitant des niveaux discrets d'alimentation, chaque tension de drain appliquée est définie pour une plage donnée de puissance d'entrée de l'amplificateur de puissance RF, l'étendue de chaque plage dépendant principalement du nombre de niveaux discrets. Ce type de technique est obligatoirement couplé à une technique de pré-distorsion du signal RF afin de préserver la linéarité globale de l'émetteur RF.

L'amplification de puissance de signaux RF et hyperfréquences, permettant d'atteindre à la fois un bon rendement et une bonne linéarité, s'avère très complexe et nécessite systématiquement un compromis entre rendement et linéarité. La technique de suivi d'enveloppe permet de grandement améliorer le compromis entre rendement et linéarité pour les applications de forte puissance, c'est-à-dire à partir de 2 Watts.

La problématique réside alors dans la capacité à disposer de convertisseurs continu-continu capables de fournir de fortes puissances, d'avoir un très bon rendement, d'être extrêmement linéaires, de générer peu de bruit et surtout de supporter de larges bandes de modulation.

Quelle que soit la technique de suivi d'enveloppe mise en oeuvre, le rendement des convertisseurs continu-continu diminue lorsque la bande passante du signal modulé augmente. Il apparaît ainsi complexe d'utiliser une technique de suivi d'enveloppe pour des applications de forte puissance avec des signaux de communications modernes à large bande passante.

Les convertisseurs continu-continu pour la technique de suivi d'enveloppe doivent disposer de bandes passantes largement supérieures à la bande passante du signal RF à émettre. Face à l'augmentation croissante des bandes passantes des signaux de télécommunications modernes, il apparaît relativement complexe de disposer de convertisseurs continu-continu ayant un bon rendement, une large bande passante et un faible coût pour des applications de forte puissance.

Conjointement à la technique de suivi d'enveloppe continue, afin de diminuer les contraintes qui pèsent sur le convertisseur continu-continu, une technique dite de réduction de bande peut être utilisée. Elle permet de diminuer l'occupation spectrale du signal de commande de polarisation. Cependant, la réduction de bande passante du signal de commande de polarisation induit nécessairement une chute de rendement de l'amplificateur de puissance RF, étant donné que le signal de commande ne suit plus exactement l'enveloppe du signal à émettre. Les techniques de réduction de bande sont complexes à mettre en oeuvre et ne permettent pas toujours d'envisager de très larges bandes de modulation avec un bon rendement global du système.

La technique particulière de suivi d'enveloppe multi-niveaux permet d'atteindre de plus larges bandes passantes de modulation que la technique de suivi d'enveloppe continue. Du fait du faible nombre de niveaux discrets, généralement compris entre 4 et 8, 16 au maximum, la technique de suivi d'enveloppe multi-niveaux ne permet pas d'obtenir des rendements d'amplificateur de puissance

RF aussi bons qu'avec un signal de commande continu. Toutefois, les pertes globales dans le convertisseur continu-continu sont nettement plus faibles.

Cette méthode particulière de la technique de suivi d'enveloppe, dont la linéarisation est plus complexe à mettre en oeuvre, permet potentiellement d'atteindre des bandes passantes de modulation très importantes. Cependant, dès lors que la bande passante de modulation augmente, les niveaux de tension du signal de commande peuvent avoir des durées trop courtes vis-à-vis des capacités du convertisseur continu-continu. Ceci risque alors de conduire à une chute importante du rendement du convertisseur continu-continu, à des erreurs d'émission ou encore à la détérioration de l'amplificateur de puissance RF si celui-ci fonctionne à trop forte compression.

Les convertisseurs continu-continu doivent, pour chacune des solutions, toujours présenter des vitesses de commutation très élevées afin de respecter au mieux les caractéristiques de l'enveloppe du signal modulé. La technique de suivi d'enveloppe multi-niveaux permet d'améliorer significativement le compromis rendement - bande passante, sans le solutionner pour de larges bandes passantes de modulation, du fait que les récurrences des commutations du convertisseur continu-continu demeurent importantes en nombre et parfois les durées des niveaux de tension trop brèves.

Le manque d'adéquation entre les capacités en vitesse de commutation du convertisseur continu-continu et les caractéristiques du signal de commande à générer ne permet pas d'appliquer la technique de suivi d'enveloppe multi-niveaux pour atteindre de très larges bandes de modulation sans dysfonctionnement du système ou erreurs d'émission. <Insérer la page 5A>

La demande de brevet américain US2015/194933A1 divulgue un système d'amplification de puissance utilisant la technique de suivi d'enveloppe continue. L'étage d'alimentation est réalisé en combinant, via des additionneurs de tension, un bloc de sélection d'alimentation à un bloc d'ajustement de la tension d'alimentation qui est constitué d'un ou plusieurs amplificateurs analogiques linéaires permettant de générer un signal de suivi d'enveloppe continue, c'est-à-dire présentant une infinité de niveaux de tension d'alimentation à l'amplificateur de puissance RF.

La demande de brevet américain US2011/316623A1 décrit un système d'amplification de puissance RF mettant en œuvre un procédé de suivi de la puissance moyenne. Ce procédé très répandu, connu sous la dénomination d'APT pour « Average Power Tracking », permet de réduire la consommation des amplificateurs. Ce procédé s'avère inadapté dans le cas de signaux à forts PAPR (Peak to Average Power Ratio). De ce fait, il est couplé à une technique de réduction de PAPR visant à écrêter les signaux à émettre au-delà d'un seuil.

La demande internationale PCT WO2016015256A1 décrit un procédé pour commander la tension d'alimentation d'un amplificateur de puissance, consistant à acquérir l'état d'une enveloppe d'un signal à amplifier ; lorsque l'état de l'enveloppe est un flan descendant, à acquérir une première tension correspondant à l'enveloppe, et à commander la tension d'alimentation selon la première tension ; et lorsque l'état de l'enveloppe est un flanc montant, à acquérir une seconde tension correspondant au pic maximal du signal à amplifier dans une première période de temps préétablie ; et à commander la tension d'alimentation selon la seconde tension dans la première période de temps préétablie. Cependant, la première tension est un signal de suivi d'enveloppe continue, c'est-à-dire présentant une infinité de niveaux de tension d'alimentation à l'amplificateur de puissance, et la seconde tension n'est pas sélectionnée parmi N niveaux discrets possibles selon une fenêtre temporelle glissante.

La présente invention vise à résoudre les inconvénients de l'état antérieur de la technique, en proposant un système de suivi de la puissance crête d'un signal de télécommunication à émettre pour une amplification de puissance RF dudit signal de télécommunication à émettre comprenant une logique de pilotage du convertisseur continu-continu permettant de repousser grandement la limitation rendement - bande passante imposée par les convertisseurs continu-continu afin de rendre applicable la technique de suivi d'enveloppe à des applications de forte puissance avec des débits élevés, ledit système permettant de générer un signal de commande de forte puissance adapté pour des applications à très large bande de modulation sans nécessairement nécessiter de disposer de convertisseurs, et donc de transistors de commutation, ultra rapides capables de commuter de forts courants en un temps très court, ledit système permettant par ailleurs de conserver un très bon rendement sur les convertisseurs continu-continu même pour de larges bandes de modulation.

La logique de pilotage consiste entre autres en l'analyse et la détection de la valeur maximale du signal de commande de suivi d'enveloppe sur une fenêtre temporelle glissante, puis en l'application, à la place d'un signal de commande de suivi d'enveloppe classique, d'un niveau de tension d'alimentation sur l'amplificateur de puissance RF parmi un certain nombre de niveaux de tension disponibles, ledit niveau de tension étant appliqué pendant une durée minimale égale à la durée de la fenêtre temporelle glissante. L'invention permet ainsi la génération d'un signal d'alimentation de type discret lentement variable vis-à-vis de la bande de modulation du signal, ces caractéristiques permettant l'utilisation d'un convertisseur continu-continu à très bas coût et fort rendement même pour de larges bandes de modulation.

L'invention propose également un procédé de calcul de valeur de crête et de sélection de tension d'alimentation mis en œuvre par un système tel que décrit ci -dessus, et une antenne RF équipée d'un tel système ou mettant en œuvre un tel procédé.

La présente invention a donc pour objet un système de suivi de la puissance crête d'un signal de télécommunication à émettre pour une amplification de puissance RF dudit signal de télécommunication à émettre, comprenant un amplificateur de puissance RF ayant une entrée RF, une entrée de tension d'alimentation et une sortie RF, un dispositif de traitement numérique, un convertisseur numérique-RF, et un convertisseur continu- continu, le dispositif de traitement numérique ayant une entrée apte à recevoir le signal de télécommunication à émettre sous forme de données numériques, une première sortie reliée à une entrée du convertisseur numérique-RF et une seconde sortie reliée à une entrée du convertisseur continu-continu, le convertisseur numérique-RF ayant une sortie reliée à l'entrée RF de l'amplificateur de puissance RF, le convertisseur continu-continu ayant une sortie reliée à l'entrée de tension d'alimentation de l'amplificateur de puissance RF, le dispositif de traitement numérique comprenant entre son entrée et sa première sortie, un élément de retard τ et entre son entrée et sa seconde sortie une chaîne de traitement, caractérisé par le fait que la sortie du convertisseur continu-continu pouvant peut une valeur de tension discrète parmi N valeurs de tension discrètes, N étant un nombre entier supérieur ou égal à 2, la chaîne de traitement comprenant une logique de commande de suivi d'enveloppe apte à créer un signal de commande de suivi d'enveloppe à N niveaux discrets à partir des données numériques reçues au niveau de l'entrée du dispositif de traitement numérique, ledit signal de commande de suivi d'enveloppe à N niveaux discrets étant échantillonné à une fréquence d'échantillonnage prédéterminée, la chaîne de traitement comprenant en outre, en aval de la logique de commande de suivi d'enveloppe, une logique de pilotage du convertisseur continu-continu comprenant un dispositif de calcul de valeur de crête et un dispositif de sélection de tension d'alimentation, le dispositif de calcul de valeur de crête étant apte :
- à fenêtrer le signal de commande de suivi d'enveloppe à N niveaux discrets, à l'aide d'une fenêtre temporelle glissante dont la durée est définie par un nombre prédéfini d'échantillons du signal de commande de suivi d'enveloppe à N niveaux discrets, le décalage entre fenêtres temporelles étant égal à un échantillon du signal de commande de suivi d'enveloppe à N niveaux discrets, et
- à calculer la valeur maximale du signal de commande de suivi d'enveloppe à N niveaux discrets sur chaque fenêtre temporelle de la fenêtre temporelle glissante, et le dispositif de sélection de tension d'alimentation étant apte à commander le convertisseur continu-continu afin d'imposer à chaque instant à la sortie de ce dernier, parmi les N valeurs de tension discrètes, en fonction de la valeur maximale du signal de commande de suivi d'enveloppe à N niveaux discrets sur la fenêtre temporelle courante, de la valeur du signal de commande de suivi d'enveloppe à N niveaux discrets retardé de la durée de la fenêtre temporelle glissante et de la valeur courante de la sortie du dispositif de sélection de tension d'alimentation, une valeur de tension discrète
d'alimentation supérieure ou égale au signal de commande de suivi d'enveloppe à N niveaux discrets, ladite valeur de tension discrète d'alimentation étant appliquée pendant une durée minimale égale à la durée de la fenêtre temporelle glissante.

Selon une caractéristique particulière de l'invention, l'élément de retard τ est choisi tel que le signal RF correspondant à des données numériques du signal de télécommunication à émettre au niveau de l'entrée RF de l'amplificateur de puissance RF est synchronisé avec la tension d'alimentation de type suivi d'enveloppe du signal RF pour ces mêmes données numériques au niveau de l'entrée de tension d'alimentation de l'amplificateur de puissance RF.

Les données numériques du signal de télécommunication à émettre sont, de préférence, des données de modulation en bande de base (I et Q).

La logique de commande de la chaîne de traitement est configurée pour mettre en oeuvre une loi de commande de suivi d'enveloppe à niveaux discrets, le signal de commande de suivi d'enveloppe à niveaux discrets créé étant échantillonné à une fréquence d'échantillonnage prédéterminée.

La fréquence d'échantillonnage prédéterminée est de préférence comprise entre 10 MHz et 500 MHz, l'homme du métier sachant adapter la fréquence d'échantillonnage prédéterminée en fonction du débit du signal à émettre.

L'invention proposée consiste à générer un signal de commande de type discret optimal à chaque instant dont la durée de chaque niveau de tension discrète respecte une durée minimale sans pour autant être d'une durée plus importante que nécessaire afin d'obtenir le meilleur rendement global du système. Le signal de commande généré permet d'être compatible avec les spécificités d'un signal de suivi d'enveloppe pour ne pas surcomprimer l'amplificateur de puissance RF et conduire à un dysfonctionnement du système.

L'invention ne permet pas d'obtenir un rendement d'amplificateur de puissance RF aussi bon qu'avec un signal de commande de suivi d'enveloppe continûment variable, mais permet de rester assez proche du rendement maximal pouvant être atteint par l'amplificateur de puissance RF. Cependant, l'invention proposée permet de grandement minimiser les pertes au sein du convertisseur continu-continu, même pour des applications à très large bande de modulation, ce qui permet d'obtenir un rendement global significativement meilleur.

Le signal de commande de l'amplificateur de puissance RF ne peut prendre qu'une valeur de tension à la fois parmi les N niveaux possibles et ces niveaux de tension ne s'adaptent pas aux variations rapides du signal d'enveloppe, le niveau de tension sélectionné étant appliqué pendant une durée minimale égale à la fenêtre temporelle glissante. Les choix du nombre N de niveaux et de la durée de la fenêtre temporelle glissante dépendent principalement des capacités du convertisseur continu-continu, du débit de symboles à émettre et du format de modulation (par exemple, QAM (modulation d'amplitude en quadrature) ou OFDM).

Ainsi, l'invention proposée permet de repousser grandement la limitation rendement - bande passante imposée par les convertisseurs continu-continu afin de rendre applicable la technique de suivi d'enveloppe à des applications de forte puissance avec des débits élevés, ledit système permettant de générer un signal de commande de forte puissance adapté pour des applications à très large bande de modulation sans nécessairement avoir à disposer de convertisseurs, et donc de transistors de commutation, ultra rapides capables de commuter de forts courants en un temps très court, ledit système permettant par ailleurs de conserver un très bon rendement sur les convertisseurs continu-continu même pour de larges bandes de modulation.

Pour chaque échantillon numérique du signal de commande de suivi d'enveloppe à N niveaux discrets, le dispositif de calcul de valeur de crête permet de déterminer la valeur maximale dudit signal sur une durée de fenêtre temporelle glissante consécutive à chaque échantillon. Cette information, conjointement à la connaissance du niveau de tension actuellement appliqué à l'amplificateur de puissance RF et de la valeur du signal de commande de suivi d'enveloppe à niveaux discrets retardé de la durée de la fenêtre temporelle glissante, permet de déterminer si un changement de niveau de tension est nécessaire.

La tension discrète fournie à l'amplificateur de puissance RF est toujours supérieure à la tension de commande qui serait issue d'un signal de commande de suivi d'enveloppe continu afin de veiller au bon fonctionnement de l'amplificateur de puissance RF, c'est-à-dire afin d'éviter toute compression excessive de l'amplificateur de puissance RF.

Dans le cas du signal issu du système proposé par l'invention, chaque niveau de tension a une durée minimale. Au-delà cette durée minimale, la durée d'un niveau de tension de commande est uniquement un multiple de la période d'échantillonnage du signal numérique.

Ce type de pilotage permet de diminuer fortement les contraintes sur le convertisseur continu-continu en termes de vitesse de commutation et ainsi d'obtenir un très bon rendement de convertisseur continu-continu. Par ailleurs, le rendement de l'amplificateur de puissance RF ne sera jamais optimal même si le nombre de niveaux discrets est suffisant. La perte de rendement de l'amplificateur de puissance RF s'avère en réalité faible vis-à-vis du gain de rendement obtenu sur le convertisseur continu-continu et du gain obtenu sur la bande passante du système.

Dans le cas d'un signal de commande utilisant la technique de l'invention, l'utilisation à un instant donné d'une tension de commande dépend de la puissance d'entrée de l'amplificateur de puissance RF, de la tension de commande actuellement appliquée à l'amplificateur de puissance RF mais aussi de la tension crête de l'enveloppe du signal modulé à venir sur une durée déterminée par la fenêtre temporelle glissante d'analyse de la valeur crête.

Les niveaux de tension générés peuvent être répartis uniformément ou non uniformément selon les caractéristiques électriques de l'amplificateur de puissance RF à alimenter.

De plus, la logique de pilotage est simple à mettre en oeuvre dans un circuit numérique, rendant ainsi minimal le nombre de circuits logiques nécessaires dans les circuits numériques ainsi que leur fréquence de fonctionnement, ce qui se traduit par une consommation électrique plus faible et un coût d'approvisionnement des circuits plus réduit. L'invention permet également l'utilisation d'un convertisseur continu-continu moins rapide et donc à faible coût de fabrication.

En outre, cette logique de pilotage permet de s'affranchir des effets de seuil pouvant conduire dans certains cas à des impulsions très courtes et donc à des erreurs d'émission.

Le retard τ permet de synchroniser la bonne tension d'alimentation de l'amplificateur de puissance RF en fonction des données en entrée.

Selon une caractéristique particulière de l'invention, le dispositif de sélection de tension d'alimentation comprend un compteur temporel configuré pour être réinitialisé et déclenché à chaque changement d'état de sortie du dispositif de sélection de tension d'alimentation, ledit dispositif de sélection de tension d'alimentation étant configuré pour ne pas changer l'état de sa sortie tant que le compteur temporel n'a pas atteint la durée de la fenêtre temporelle glissante.

Ainsi, à chaque fois que la tension de commande discrète issue de la sortie du convertisseur continu-continu change d'état, le compteur temporel est réinitialisé et déclenché afin de déterminer si la durée du niveau de sortie est à chaque instant supérieure ou inférieure à la durée minimale à respecter, à savoir la durée de la fenêtre temporelle glissante.

Le dispositif de sélection de tension d'alimentation pourra, si nécessaire, changer l'état de la sortie du convertisseur continu-continu uniquement lorsque le compteur temporel aura atteint la durée de la fenêtre temporelle glissante.

Selon une caractéristique particulière de l'invention, le dispositif de sélection de tension d'alimentation comprend en outre un module de décision de changement d'état de sortie configuré pour modifier l'état de la sortie du dispositif de sélection de tension d'alimentation, à la valeur maximale du signal de commande de suivi d'enveloppe à N niveaux discrets sur la fenêtre temporelle courante, lorsque le compteur temporel a atteint la durée de la fenêtre temporelle glissante, et que la valeur maximale du signal de commande de suivi d'enveloppe à N niveaux discrets sur la fenêtre temporelle courante est inférieure à la valeur courante de la sortie du dispositif de sélection de tension d'alimentation ou que la valeur courante de la sortie du dispositif de sélection de tension d'alimentation est inférieure à la valeur du signal de commande de suivi d'enveloppe à N niveaux discrets retardé de la durée de la fenêtre temporelle glissante.

Ainsi, pour déterminer si un changement de niveau de tension est nécessaire au niveau de l'amplificateur de puissance RF, un test de type booléen est effectué dans le module de décision de changement d'état de sortie à partir de la connaissance des informations issues des différentes conditions décrites précédemment.

Selon une caractéristique particulière de l'invention, la logique de commande de suivi d'enveloppe comprend un dispositif de calcul du module du signal de télécommunication à émettre et un dispositif de création de signal de commande de suivi d'enveloppe configuré pour créer le signal de commande de suivi d'enveloppe à N niveaux discrets par comparaison de la valeur du module calculé par ledit dispositif de calcul à (N-1) seuils de commutation prédéfinis.

Ainsi, le signal de commande de suivi d'enveloppe à N niveaux discrets est généré à partir du module du signal d'enveloppe et de la connaissance des seuils de commutation d'une alimentation à l'autre. Pour un signal à N niveaux discrets, il existe (N-1) seuils de commutation.

Selon une caractéristique particulière de l'invention, le nombre de niveaux de tension N est compris entre 2 et 16.

Le choix de N dépend principalement des capacités du convertisseur continu-continu, du débit de symboles à émettre et du format de modulation.

Il est à noter que plus N est grand et plus le système est compliqué et onéreux à fabriquer.

N sera de préférence compris entre 4 et 8.

Selon une caractéristique particulière de l'invention, le nombre prédéfini d'échantillons du signal de commande de suivi d'enveloppe à N niveaux discrets définissant la durée de la fenêtre temporelle glissante est compris entre 2 et 128, en fonction de la fréquence de fonctionnement du circuit numérique et du débit à transmettre.

Selon une caractéristique particulière de l'invention, le dispositif de traitement numérique est mis en œuvre dans un circuit numérique programmable, de préférence un processeur, un microprocesseur, un microcontrôleur, un dispositif de traitement numérique de signal (DSP), un circuit intégré spécifique à une application (ASIC) ou une matrice prédiffusée programmable (FPGA).

Ainsi, le dispositif de traitement numérique peut facilement être implanté dans un circuit numérique programmable classique.

Le dispositif de traitement numérique fonctionne d'une part à une fréquence plus faible que pour les techniques de suivi d'enveloppe continue, car n'ayant plus besoin d'un signal PWM (modulation d'impulsions en largeur, « Pulse Width Modulation » en anglais) ou sigma-delta de commande, et nécessite également l'utilisation de moins de ressources numériques pour la génération du signal de commande.

L'implémentation d'une loi de commande de type fonction polynomiale ou par table n'est pas nécessaire, de simples seuils de comparaison suffisant pour la génération d'un tel signal de commande à niveaux discrets.

Selon une caractéristique particulière de l'invention, le convertisseur continu-continu est de type à multi-entrées d'alimentation en parallèle ou de type à multi-entrées d'alimentation en cascade.

De tels types de convertisseur continu-continu sont par exemple décrits dans les documents suivants :
- Garcia, O.; Vasic, M.; Alou, P.; Oliver, J.A.; Cobos, J.A., "An overview of fast DC-DC converters for envelope amplifier in RF transmitters" (Présentation de convertisseurs CC-CC rapides pour amplificateur d'enveloppe dans des émetteurs RF), Applied Power Electronics Conférence and Exposition (APEC), 2012 Twenty-Seventh Annual IEEE, pp.1313-1318, 5-9 Fev. 2012 ; et
- Florian, C.; Cappello, T.; Paganelli, R.P.; Niessen, D.; Filicori, F., "Envelope Tracking of an RF High Power Amplifier With an 8-Level Digitally Controlled GaN-on-Si Supply Modulator" (Suivi d'enveloppe d'un amplificateur RF haute puissance avec un modulateur d'alimentation GaN-sur-Si commandé numériquement sur 8 niveaux), in Microwave Theory and Techniques, IEEE Transactions, vol.63, no.8, pp.2589-2602, Août 2015.

Ainsi, ces deux types particuliers de convertisseur continu-continu sont particulièrement appropriés pour la génération de signaux multi-niveaux et permettent par ailleurs d'obtenir de bons rendements.

Il est à noter que le convertisseur continu-continu pourrait également être d'un autre type de convertisseur continu-continu approprié pour générer un signal de commande de type discret à variation maîtrisée, sans s'écarter du cadre de la présente invention.

Le convertisseur continu-continu de type à multi-entrées d'alimentation en parallèle s'appuie sur une configuration parallèle des alimentations. Différentes tensions d'alimentation sont reliées aux multiples entrées d'alimentation du convertisseur continu-continu, et l'une des tensions d'alimentation est sélectionnée, par des commutateurs à transistors de puissance, en sortie du convertisseur continu-continu, le convertisseur continu-continu possédant autant d'entrées d'alimentation que de niveaux de sortie à appliquer.

Le convertisseur continu-continu de type multi-entrées d'alimentation en cascade s'appuie sur une configuration série des alimentations. Ce type de convertisseur permet d'obtenir N niveaux de tension à partir de (ln(N)/ln(2))+1 entrées d'alimentation, où ln est la fonction logarithme népérien. Dans cette architecture, les N niveaux de tension générés sont interdépendants et les tensions de sortie ne peuvent donc pas être choisies indépendamment.

Selon une caractéristique particulière de l'invention, le convertisseur numérique-RF comprend un convertisseur numérique analogique associé à un mélangeur RF de type modulateur IQ par exemple.

Ainsi, le convertisseur numérique-RF peut tout d'abord convertir les données numériques provenant du dispositif de traitement numérique en données analogiques, par l'intermédiaire du convertisseur numérique-analogique, puis mélanger les données analogiques avec un signal RF, par l'intermédiaire du mélangeur RF.

Selon une caractéristique particulière de l'invention, le système comprend en outre un filtre passe-bas disposé entre la sortie du convertisseur continu-continu et l'entrée de tension d'alimentation de l'amplificateur de puissance RF.

Ainsi, le filtre passe-bas permet de maîtriser parfaitement les caractéristiques de transition du signal de commande de type discret d'un niveau de tension discret à un autre et également l'étalement spectral du signal de commande de type discret.

Selon une caractéristique particulière de l'invention, le dispositif de traitement numérique comprend en outre une logique de pré-distorsion qui linéarise le gain de l'amplificateur de puissance RF.

Ainsi, la logique de pré-distorsion permet de conserver une bonne linéarité de l'amplificateur de puissance RF.

La présente invention a également pour objet un procédé de calcul de valeur de crête et de sélection de tension d'alimentation mis en oeuvre par un système de suivi de la puissance crête d'un signal de télécommunication à émettre pour une amplification de puissance RF tel que décrit ci-dessus, caractérisé par le fait qu'il comprend les étapes suivantes : le fenêtrage temporel, à l'aide d'une fenêtre temporelle glissante, d'un signal de commande de suivi d'enveloppe à N niveaux discrets ; le calcul de la valeur maximale du signal de commande de suivi d'enveloppe à N niveaux discrets sur chaque fenêtre temporelle de la fenêtre temporelle glissante ; la sélection, parmi N valeurs de tension discrètes, en fonction de la valeur maximale du signal de commande de suivi d'enveloppe à N niveaux discrets sur la fenêtre temporelle courante et de la valeur du signal de commande de suivi d'enveloppe à N niveaux discrets retardé de la durée de la fenêtre temporelle glissante, d'une valeur de tension discrète d'alimentation supérieure ou égale au signal de commande de suivi d'enveloppe à N niveaux discrets, ladite valeur de tension discrète d'alimentation étant appliquée pendant une durée minimale égale à la durée de la fenêtre temporelle glissante ; et la commande d'un convertisseur continu-continu afin d'imposer à chaque instant à la sortie de ce dernier la valeur de tension discrète d'alimentation sélectionnée.

Ainsi, ledit procédé permet de limiter les contraintes en vitesse de commutation sur le convertisseur continu-continu du système d'amplification de puissance RF à suivi d'enveloppe.

Il est à noter que ladite valeur maximale calculée correspond à la valeur de l'échantillon ayant la valeur maximale parmi tous les échantillons de la fenêtre temporelle glissante courante.

La présente invention a également pour objet une antenne d'émission RF équipée d'un système de suivi de la puissance crête d'un signal de télécommunication à émettre pour une amplification de puissance RF dudit signal de télécommunication à émettre tel que décrit ci-dessus ou mettant en œuvre un procédé de calcul de valeur de crête et de sélection de tension d'alimentation tel que décrit ci-dessus.

Pour mieux illustrer l'objet de la présente invention, on va en décrire ci-après, à titre illustratif et non limitatif, des modes de réalisation préférés, avec référence aux dessins annexés.

Sur ces dessins :
- la Figure 1 est un schéma de principe d'un système de suivi de la puissance crête pour une amplification de puissance RF selon la présente invention ;
- la Figure 2 est un schéma de principe d'un dispositif de traitement numérique du système de suivi de la puissance crête pour une amplification de puissance RF selon la présente invention ;
- la Figure 3 est un organigramme illustrant un procédé de calcul de valeur de crête sur une fenêtre temporelle glissante selon la présente invention ;
- la Figure 4 est un schéma de principe d'un convertisseur continu-continu du système de suivi de la puissance crête pour une amplification de puissance RF selon un premier mode de réalisation de la présente invention ;
- la Figure 5 est un schéma de principe d'un convertisseur continu-continu du système de suivi de la puissance crête pour une amplification de puissance RF selon un second mode de réalisation de la présente invention ;
- la Figure 6 illustre des courbes à titre d'exemple de différents signaux de commande de suivi d'enveloppe dans le système de suivi de la puissance crête pour une amplification de puissance RF selon la présente invention ; et
- la Figure 7 illustre des courbes à titre d'exemple du rendement et de la puissance consommée d'un amplificateur de puissance RF du système de suivi de la puissance crête pour une amplification de puissance RF selon la présente invention en fonction du rapport de la durée de symbole à émettre sur la durée minimale des niveaux d'alimentation.

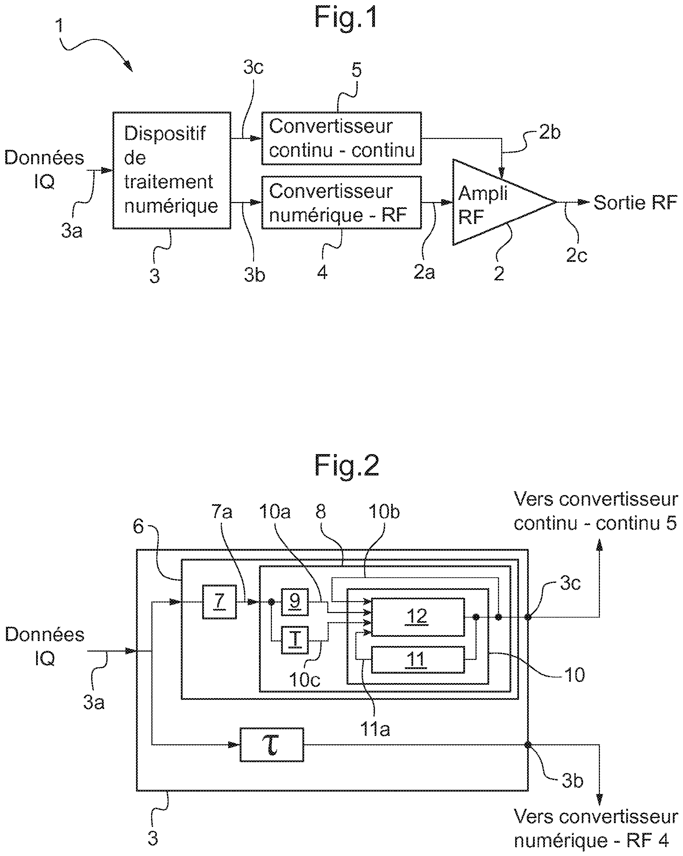

Si l'on se réfère à la Figure 1, on peut voir qu'il y est représenté un système de suivi de la puissance crête pour une amplification de puissance RF 1 selon la présente invention.

Le système de suivi de la puissance crête pour une amplification de puissance RF 1 comprend un amplificateur de puissance RF 2 ayant une entrée RF 2a, une entrée de tension d'alimentation 2b et une sortie RF 2c, un dispositif de traitement numérique 3, un convertisseur numérique-RF 4 et un convertisseur continu-continu 5.

Le dispositif de traitement numérique 3 possède une entrée 3a apte à recevoir des données numériques I/Q représentant un signal de télécommunication à émettre par voie RF par l'amplificateur de puissance RF 2, une première sortie 3b reliée à une entrée du convertisseur numérique-RF 4 et une seconde sortie 3c reliée à une entrée du convertisseur continu-continu 5.

Le convertisseur numérique-RF 4 possède une sortie reliée à l'entrée RF 2a de l'amplificateur de puissance RF.

Le convertisseur continu-continu 5 possède une sortie reliée à l'entrée de tension d'alimentation 2b de l'amplificateur de puissance RF 2, la sortie du convertisseur continu-continu 5 pouvant prendre une valeur de tension discrète parmi N valeurs de tension discrètes, N étant un nombre entier supérieur ou égal à 2, de préférence compris entre 2 et 8.

L'amplificateur de puissance RF 2 comprend des éléments de puissance à semi-conducteurs tels que des transistors de puissance à semi-conducteurs (non représentés à la Figure 1).

Le convertisseur numérique-RF 4 comprend un convertisseur numérique-analogique associé à un mélangeur RF (non représentés à la Figure 1), le convertisseur numérique-analogique convertissant les données numériques provenant du dispositif de traitement numérique 3 en données analogiques, et le mélangeur RF mélangeant lesdites données analogiques avec un signal RF.

Le dispositif de traitement numérique 3 et le convertisseur continu-continu 5 seront décrits plus en détail ci-après.

Ce système 1 permet ainsi d'appliquer une technique de suivi d'enveloppe à niveaux discrets afin d'améliorer le rendement de l'amplificateur de puissance RF 2, l'alimentation de l'amplificateur de puissance RF 2 étant dynamique et suivant l'amplitude du signal RF à émettre, l'amplificateur de puissance RF 2 fonctionnant ainsi toujours en compression et donc à son rendement maximal quel que soit le niveau de puissance de l'enveloppe du signal RF.

Le signal de commande de l'amplificateur de puissance RF 2, au niveau de son entrée de tension d'alimentation 2b, peut dynamiquement prendre l'une des N valeurs de tension discrètes possibles afin de suivre l'enveloppe du signal RF à émettre.

Les valeurs de tension discrètes peuvent être réparties uniformément ou non uniformément selon les caractéristiques électriques de l'amplificateur de puissance RF 2 à alimenter.

Si l'on se réfère à la Figure 2, on peut voir qu'il y est représenté le dispositif de traitement numérique 3 du système de suivi de la puissance crête pour une amplification de puissance RF 1 selon la présente invention.

Le dispositif de traitement numérique 3 comprend, entre son entrée 3a et sa première sortie 3b, un élément de retard τ et, entre son entrée 3a et sa seconde sortie 3c, une chaîne de traitement 6.

La chaîne de traitement 6 comprend une logique de commande de suivi d'enveloppe 7 apte à créer un signal de commande de suivi d'enveloppe à N niveaux discrets 7a à partir des données numériques reçues au niveau de l'entrée 3a du dispositif de traitement numérique 3, ledit signal de commande de suivi d'enveloppe à N niveaux discrets 7a étant échantillonné à une fréquence d'échantillonnage prédéterminée.

La fréquence d'échantillonnage prédéterminée est de préférence comprise entre 10 MHz et 500 MHz.

La logique de commande de suivi d'enveloppe 7 comprend un dispositif de calcul du module du signal de télécommunication à émettre (non représenté à la Figure 2) et un dispositif de création de signal de commande de suivi d'enveloppe (non représenté à la Figure 2) configuré pour créer le signal de commande de suivi d'enveloppe à N niveaux discrets 7a par comparaison de la valeur du module calculé par ledit dispositif de calcul à (N-1) seuils de commutation prédéfinis d'une alimentation à l'autre, ledit signal de commande de suivi d'enveloppe à N niveaux discrets 7a étant supérieur ou égal à un signal de commande de suivi d'enveloppe qui serait de type continu.

Par exemple, dans le cas où N = 4, si M(n) est le module de l'enveloppe du signal modulé pour l'échantillon n et S1, S2 et S3 sont les trois seuils de commutation des quatre niveaux d'alimentation V1, V2, V3 et V4, le signal de commande de suivi d'enveloppe à 4 niveaux discrets peut alors prendre l'un des quatre niveaux discrets disponibles suivants :
- V1 si M(n) ≤ S1 ;
- V2 si S1 < M(n) ≤ S2 ;
- V3 si S2 < M(n) ≤ S3 ; et
- V4 si S3 < M(n).

La chaîne de traitement 6 comprend en outre, en aval de la logique de commande de suivi d'enveloppe 7, une logique de pilotage 8 du convertisseur continu-continu 5 comprenant un dispositif de calcul de valeur de crête 9 et un dispositif de sélection de tension d'alimentation 10.

Le dispositif de calcul de valeur de crête 9 est apte à fenêtrer, à l'aide d'une fenêtre temporelle glissante dont la durée est définie par un nombre prédéfini d'échantillons du signal de commande de suivi d'enveloppe à N niveaux discrets 7a, le décalage entre fenêtres temporelles étant égal à un échantillon du signal de commande de suivi d'enveloppe à N niveaux discrets 7a, le signal de commande de suivi d'enveloppe à N niveaux discrets 7a provenant de la logique de commande de suivi d'enveloppe 7 et à calculer la valeur maximale 10a du signal de commande de suivi d'enveloppe à N niveaux discrets 7a sur chaque fenêtre temporelle de la fenêtre temporelle glissante.

Le nombre prédéfini d'échantillons du signal de commande de suivi d'enveloppe à N niveaux discrets 7a définissant la durée de la fenêtre temporelle glissante est de préférence compris entre 2 et 128.

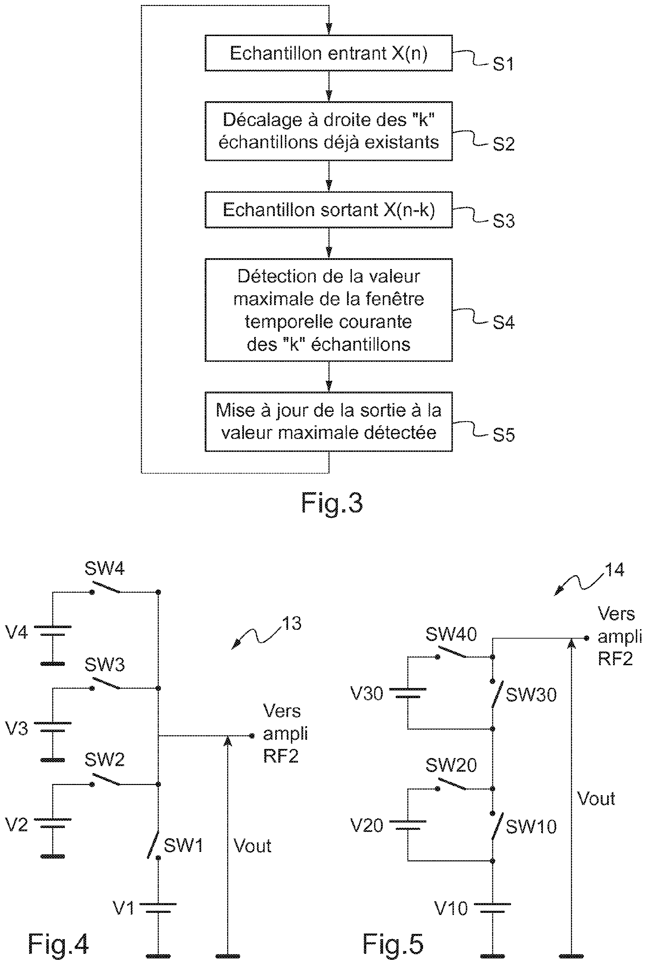

Le procédé de calcul de valeur de crête mis en oeuvre par le dispositif de calcul de valeur de crête 9 sera décrit plus en détail à la Figure 3.

Le dispositif de sélection de tension d'alimentation 10 est apte à commander le convertisseur continu-continu 5 afin d'imposer à la sortie de ce dernier, parmi les N valeurs de tension discrètes, en fonction entre autres de la valeur maximale 10a du signal de commande de suivi d'enveloppe à N niveaux discrets 7a sur la fenêtre temporelle courante, une valeur de tension discrète d'alimentation supérieure ou égale au signal de commande de suivi d'enveloppe à N niveaux discrets 7a afin de ne pas surcomprimer l'amplificateur de puissance RF 2, ladite valeur de tension discrète d'alimentation étant appliquée pendant une durée minimale égale à la durée de la fenêtre temporelle glissante.

L'élément de retard τ est choisi tel que le signal RF correspondant à des données numériques du signal de télécommunication à émettre au niveau de l'entrée RF 2a de l'amplificateur de puissance RF 2 est synchronisé avec la tension d'alimentation de type suivi d'enveloppe du signal RF pour ces mêmes données numériques au niveau de l'entrée de tension d'alimentation 2b de l'amplificateur de puissance RF 2.

Le dispositif de sélection de tension d'alimentation 10 comprend un compteur temporel 11 et un module de décision de changement d'état de sortie 12.

Le compteur temporel 11 est configuré pour être réinitialisé et déclenché à chaque changement d'état de sortie du dispositif de sélection de tension d'alimentation 10, afin de déterminer si la durée du niveau de sortie est à chaque instant supérieure ou inférieure à la durée de la fenêtre temporelle glissante, un signal de dépassement de durée 11a étant envoyé par le compteur temporel 11 au module de décision de changement d'état de sortie 12 lorsque la durée du niveau de sortie est supérieure à la durée de la fenêtre temporelle glissante.

Le module de décision de changement d'état de sortie 12 est configuré pour modifier l'état de la sortie du dispositif de sélection de tension d'alimentation 10, à la valeur maximale 10a du signal de commande de suivi d'enveloppe à N niveaux discrets 7a sur la fenêtre temporelle courante, lorsque le test booléen suivant est vrai : (le compteur temporel 11 a atteint la durée de la fenêtre temporelle glissante) ET ((la valeur maximale 10a du signal de commande de suivi d'enveloppe à N niveaux discrets 7a sur la fenêtre temporelle courante est inférieure à la valeur courante 10b de la sortie du dispositif de sélection de tension d'alimentation 10) OU (la valeur courante 10b de la sortie du dispositif de sélection de tension d'alimentation 10 est inférieure à la valeur 10c du signal de commande de suivi d'enveloppe à N niveaux discrets 7a retardé de la durée T de la fenêtre temporelle glissante)).

La tension discrète fournie à l'amplificateur de puissance RF 1 est toujours supérieure à la tension de commande qui serait issue d'un signal de commande de suivi d'enveloppe continu afin de veiller au bon fonctionnement de l'amplificateur de puissance RF 2, c'est-à-dire afin d'éviter toute compression excessive de l'amplificateur de puissance RF 2.

Dans le cas du signal issu du système proposé par l'invention, chaque niveau de tension a une durée égale à la durée de la fenêtre temporelle glissante. Au-delà cette durée minimale, la durée d'un niveau de tension de commande est uniquement un multiple de la période d'échantillonnage du signal de commande de suivi d'enveloppe à N niveaux discrets 7a.

Il est à noter que le dispositif de traitement numérique 3 pourrait également comprendre une logique de pré-distorsion qui linéarise le gain de l'amplificateur de puissance RF 2, sans s'écarter du cadre de la présente invention.

Il est à noter que la totalité du dispositif de traitement numérique 3 est mis en oeuvre dans un circuit numérique programmable, de préférence un processeur, un microprocesseur, un microcontrôleur, un dispositif de traitement numérique de signal (DSP), un circuit intégré spécifique à une application (ASIC) ou une matrice prédiffusée programmable (FPGA).

Si l'on se réfère à la Figure 3, on peut voir qu'il y est représenté un organigramme illustrant un procédé de calcul de valeur de crête mis en oeuvre par le dispositif de calcul de valeur de crête 9 selon la présente invention.

Le dispositif de calcul de valeur de crête 9 est configuré pour réaliser une fonction de calcul de la valeur de crête du signal de commande de suivi d'enveloppe à N niveaux discrets 7a sur une fenêtre temporelle glissante de durée T, cette durée T étant réalisée par la prise de « k » échantillons numériques dudit signal de commande de suivi d'enveloppe à N niveaux discrets 7a.

Cette fonction de calcul est d'autant plus aisée à réaliser en pratique que le nombre N de niveaux discrets est faible. Le nombre N de niveaux discrets étant généralement compris entre 4 et 8, le coût numérique associé est par conséquent relativement limité.

Le procédé de calcul de valeur de crête mis en oeuvre par le dispositif de calcul de valeur de crête 9 comprend les étapes suivantes :
- S1 : l'entrée, dans le dispositif de calcul de valeur de crête 9, d'un échantillon X(n) du signal de commande de suivi d'enveloppe à N niveaux discrets 7a, n étant le numéro dudit échantillon entrant ;
- S2 : le décalage vers la droite des k échantillons du signal de commande de suivi d'enveloppe à N niveaux discrets 7a déjà existants dans le dispositif de calcul de valeur de crête 9 ;
- S3 : la sortie de l'échantillon X(n-k) du signal de commande de suivi d'enveloppe à N niveaux discrets 7a déjà existant dans le dispositif de calcul de valeur de crête 9 ;

- S4 : la détection de la valeur maximale parmi les k échantillons de la fenêtre temporelle courante existants actuellement dans le dispositif de calcul de valeur de crête 9 ; et
- S5 : la mise à jour de la sortie du dispositif de calcul de valeur de crête 9 à la valeur maximale détectée.

Pour chaque échantillon numérique du signal de commande de suivi d'enveloppe à N niveaux discrets 7a, la fenêtre temporelle glissante permet de déterminer la valeur maximale du signal sur une durée T consécutive à chaque échantillon.

Il est à noter que ladite valeur maximale calculée correspond à la valeur de l'échantillon ayant la valeur maximale parmi tous les échantillons de la fenêtre temporelle glissante courante.

L'invention porte également sur un procédé de calcul de valeur de crête et de sélection de tension d'alimentation mis en oeuvre par le système de suivi de la puissance crête d'un signal de télécommunication à émettre pour une amplification de puissance RF 1, caractérisé par le fait qu'il comprend les étapes suivantes :
- le fenêtrage temporel, à l'aide d'une fenêtre temporelle glissante, d'un signal de commande de suivi d'enveloppe à N niveaux discrets 7a ;
- le calcul de la valeur maximale 10a du signal de commande de suivi d'enveloppe à N niveaux discrets 7a sur chaque fenêtre temporelle de la fenêtre temporelle glissante ;
- la sélection, parmi N valeurs de tension discrètes, en fonction de la valeur maximale 10a du signal de commande de suivi d'enveloppe à N niveaux discrets 7a sur la fenêtre temporelle courante et de la valeur 10c du signal de commande de suivi d'enveloppe à N niveaux discrets 7a retardé de la durée T de la fenêtre temporelle glissante, d'une valeur de tension discrète d'alimentation supérieure ou égale au signal de commande de suivi d'enveloppe à N niveaux discrets 7a, ladite valeur de tension discrète d'alimentation étant appliquée pendant une durée minimale égale à la durée T de la fenêtre temporelle glissante ; et
- la commande d'un convertisseur continu-continu 5 afin d'imposer à la sortie de ce dernier la valeur de tension discrète d'alimentation sélectionnée.

Si l'on se réfère à la Figure 4, on peut voir qu'il y est représenté un convertisseur continu-continu de type à multi-entrées d'alimentation en parallèle 13 du système de suivi de la puissance crête pour une amplification de puissance RF 1 selon un premier mode de réalisation de la présente invention.

Selon ce premier mode de réalisation, le convertisseur continu-continu 5 est un convertisseur continu-continu de type à multi-entrées d'alimentation en parallèle 13.

Dans ce premier mode de réalisation à titre d'exemple, le convertisseur continu-continu de type à multi-entrées d'alimentation en parallèle 13 comporte quatre tensions d'alimentation différentes et de valeurs indépendantes V1, V2, V3 et V4, quatre étant le nombre souhaité de valeurs de tension discrètes possibles à la sortie du convertisseur continu-continu 13, et quatre commutateurs à transistors de puissance SW1, SW2, SW3 et SW4 comportant chacun des première et seconde bornes, les premières bornes des quatre commutateurs SW1 à SW4 étant respectivement reliées aux quatre tensions d'alimentation V1 à V4, et les secondes bornes des quatre commutateurs SW1 à SW4 étant reliées à la tension de sortie Vout du convertisseur continu-continu 13.

Il est à noter que le convertisseur continu-continu 13 pourrait également comporter un nombre N de tensions d'alimentation et de commutateurs, sans s'écarter du cadre de la présente invention.

Les quatre tensions d'alimentation V1 à V4, ainsi que la tension de sortie Vout, sont référencées par rapport à la masse du circuit.

Le module de décision de changement d'état de sortie 12 intègre également une logique de pilotage de commutateurs.

Les quatre commutateurs SW1 à SW4 sont commandés dynamiquement par le module de décision de changement d'état de sortie 12 du dispositif de traitement numérique 3, de telle sorte qu'un seul commutateur parmi les quatre commutateurs SW1 à SW4 est fermé à la fois afin d'appliquer la tension d'alimentation associée au niveau de la tension de sortie Vout.

Ainsi, le convertisseur continu-continu 13 peut générer un signal de commande de type discret à variation lente dont la vitesse de commutation n'est pas l'élément prépondérant, ce convertisseur continu-continu 13 ayant un excellent rendement de conversion.

Le convertisseur continu-continu de type à multi-entrées d'alimentation en parallèle 13 s'appuie ainsi sur une configuration parallèle des tensions d'alimentation V1 à V4, ledit convertisseur continu-continu 13 possédant autant d'entrées de tensions d'alimentation que de niveaux de sortie à appliquer.

Il est à noter que le convertisseur continu-continu 13 pourrait en outre comprendre un filtre passe-bas disposé entre la sortie Vout du convertisseur continu-continu 13 et l'entrée de tension d'alimentation 2b de l'amplificateur de puissance RF 2, sans s'écarter du cadre de la présente invention. Dans ce cas, le filtre passe-bas peut être un simple circuit résonant LC (inductancecondensateur) ou un filtre passe-bas d'ordre supérieur ou égal à 2.

Si l'on se réfère à la Figure 5, on peut voir qu'il y est représenté un convertisseur continu-continu de type à multi-entrées d'alimentation en cascade 14 du système de suivi de la puissance crête pour une amplification de puissance RF 1 selon un second mode de réalisation de la présente invention.

Selon ce second mode de réalisation, le convertisseur continu-continu 5 est un convertisseur continu-continu de type à multi-entrées d'alimentation en cascade 14.

Le convertisseur continu-continu de type multi-entrées d'alimentation en cascade 14 s'appuie sur une configuration série des tensions d'alimentation. Ce type de convertisseur continu-continu permet d'obtenir N niveaux discrets possibles à partir de (ln(N)/ln(2))+1 entrées de tensions d'alimentation, les N niveaux discrets générés étant interdépendants et les tensions d'alimentation ne pouvant donc pas être choisies indépendamment.

Le convertisseur continu-continu de type à multi-entrées d'alimentation en cascade 14 à titre d'exemple comporte trois tensions d'alimentation différentes V10, V20 et V30, et quatre commutateurs à transistors de puissance SW10, SW20, SW30 et SW40 comportant chacun des première et seconde bornes.

Il est à noter que le convertisseur continu-continu 14 pourrait également comporter un nombre (ln(N)/ln(2))+1 de tensions d'alimentation et un nombre 2*(ln(N)/ln(2)) de commutateurs, sans s'écarter du cadre de la présente invention.

La seconde borne du premier commutateur SW10 est reliée à la borne positive de la première tension d'alimentation V10 et à la borne négative de la seconde tension d'alimentation V20.

La première borne du premier commutateur SW10 est reliée à la seconde borne du second commutateur SW20, à la seconde borne du troisième commutateur SW30 et à la borne négative de la troisième tension d'alimentation V30.

La première borne du second commutateur SW20 est reliée à la borne positive de la seconde tension d'alimentation V20.

La première borne du quatrième commutateur SW40 est reliée à la borne positive de la quatrième tension d'alimentation V30.

La tension de sortie Vout du convertisseur continu-continu 14 est reliée à la première borne du troisième commutateur SW30 et à la seconde borne du quatrième commutateur SW40.

Les quatre commutateurs SW10 à SW40 sont commandés dynamiquement par le module de décision de changement d'état de sortie 12 du dispositif de traitement numérique 3, de telle sorte que la tension de sortie Vout est égale à :
- V10 lorsque les commutateurs SW10 et SW30 sont fermés et que les commutateurs SW20 et SW40 sont ouverts ;
- (V10 + V20) lorsque les commutateurs SW20 et SW30 sont fermés et que les commutateurs SW10 et SW40 sont ouverts ;
- (V10 + V30) lorsque les commutateurs SW10 et SW40 sont fermés et que les commutateurs SW20 et SW30 sont ouverts ; et
- (V10 + V20 + V30) lorsque les commutateurs SW20 et SW40 sont fermés et que les commutateurs SW10 et SW30 sont ouverts.

Il est à noter que le convertisseur continu-continu 14 pourrait en outre comprendre un filtre passe-bas disposé entre la sortie Vout du convertisseur continu-continu 14 et l'entrée de tension d'alimentation 2b de l'amplificateur de puissance RF 2, sans s'écarter du cadre de la présente invention. Dans ce cas, le filtre passe-bas peut être un simple circuit résonant LC (inductancecondensateur) ou un filtre passe-bas d'ordre supérieur ou égal à 2.

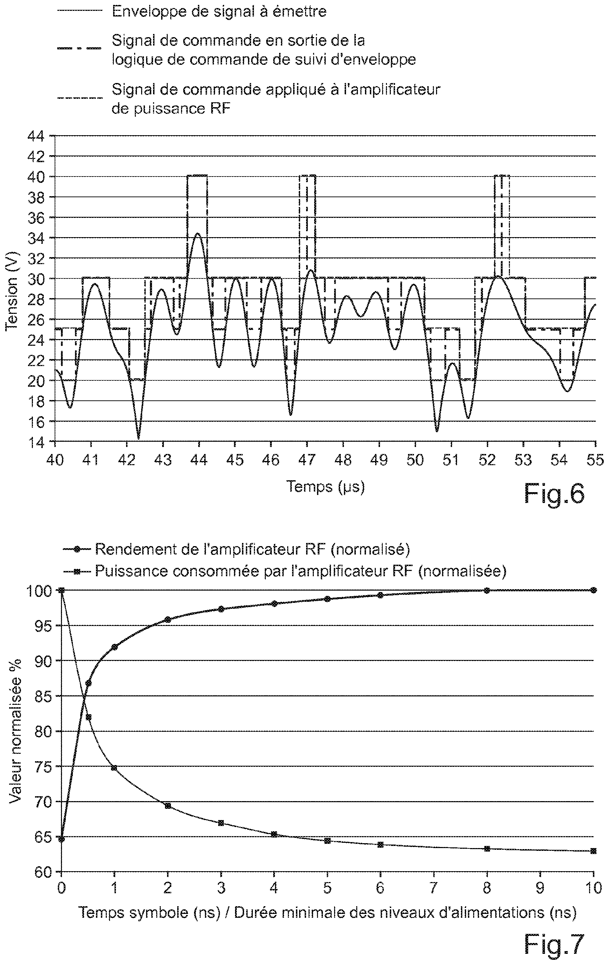

Si l'on se réfère à la Figure 6, on peut voir qu'il y est représenté des courbes à titre d'exemple de différents signaux de commande de suivi d'enveloppe dans le système de suivi de la puissance crête pour une amplification de puissance RF 1 selon la présente invention.

La courbe en trait continu représente l'enveloppe continue d'un signal à émettre à titre d'exemple, ladite enveloppe étant remise à l'échelle pour mieux comprendre les instants de commutation, ladite courbe étant représentée en tension d'alimentation au cours du temps afin de faciliter la compréhension du lecteur.

La courbe en trait mixte représente le signal de commande de suivi d'enveloppe à quatre niveaux discrets en sortie de la logique de commande de suivi d'enveloppe 7, ladite courbe étant représentée en tension d'alimentation au cours du temps.

La courbe en pointillés représente le signal de commande en sortie du convertisseur continu-continu 5 appliqué à l'amplificateur de puissance RF 2, ladite courbe étant représentée en tension d'alimentation au cours du temps.

Dans cet exemple, le procédé de calcul de valeur de crête et de sélection de tension d'alimentation est appliqué sur le signal issu de la logique de commande de suivi d'enveloppe 7 pour un signal modulé de 1 MHz de bande passante. La durée minimale de chaque niveau de tension est fixée à 400 ns ainsi que la durée de la fenêtre temporelle glissante. De plus, le convertisseur continu-continu 5 possède quatre valeurs possibles de tensions discrètes de sortie, à savoir V1 = 20 V, V2 = 25 V, V3 = 30 V et V4 = 40 V.

Chaque niveau de tension a une durée minimale de 400 ns. Au-delà de cette durée minimale, la durée d'un niveau de tension de commande est uniquement un multiple de la période d'échantillonnage du signal de commande de suivi d'enveloppe à quatre niveaux discrets fourni par la logique de commande de suivi d'enveloppe 7.

Le signal de commande appliqué à l'amplificateur de puissance RF 2 est constamment supérieur ou égal au signal de commande continu de suivi d'enveloppe afin de veiller au bon fonctionnement de l'amplificateur de puissance RF 2.

Ainsi, ce type de pilotage d'amplificateur de puissance RF 2 permet de fortement diminuer les contraintes sur le convertisseur continu-continu 5 en termes de vitesse de commutation et ainsi d'obtenir un très bon rendement de convertisseur continu-continu 5 pour de larges bandes de modulation.

Si l'on se réfère à la Figure 7, on peut voir qu'il y est représenté des courbes à titre d'exemple du rendement et de la puissance consommée d'un amplificateur de puissance RF 2 du système de suivi de la puissance crête pour une amplification de puissance RF 1 selon la présente invention en fonction du rapport de la durée de symbole à émettre sur la durée minimale des niveaux d'alimentation.

Dans cet exemple, une modulation de type 16QAM est appliquée à l'amplificateur de puissance RF 2. Le rendement mesuré pour une tension d'alimentation continue est comparé aux rendements obtenus pour différentes durées minimales de niveaux d'alimentation, c'est-à-dire pour différentes durées de fenêtre temporelle glissante. La durée minimale d'un niveau d'alimentation varie d'une durée du double de la durée d'un symbole à émettre à une durée d'un dixième de la durée d'un symbole à émettre.

Lorsque la durée minimale imposée à chaque niveau d'alimentation est très courte et égale à la période d'échantillonnage numérique, le signal de commande s'apparente alors à un signal de suivi d'enveloppe discret standard sans aucun effet de l'invention.

Dans cet exemple, quatre niveaux d'alimentation discrets sont utilisés pour commander l'amplificateur de puissance RF 2. L'axe des abscisses à zéro correspond aux caractéristiques (rendement d'environ 65% du rendement maximum et puissance consommée de 100%) de l'amplificateur de puissance RF 2 pour une tension d'alimentation fixe, c'est-à-dire une durée minimale de niveaux d'alimentation infinie.

Une durée minimale pour chaque niveau d'alimentation de la moitié du temps symbole du signal à émettre permet avec quatre niveaux d'alimentation d'obtenir un rendement d'amplificateur de puissance RF 2 proche du rendement maximal pouvant être atteint avec la technique de suivi d'enveloppe discrète (rendement d'environ 95% du rendement maximum et puissance consommée d'environ 70%).

L'invention permet en outre d'éliminer tout risque d'erreur d'émission du fait d'impulsions trop courtes et de garantir un rendement de convertisseur continu-continu 5 supérieur à celui des techniques de suivi d'enveloppe continu ou multi-niveaux classiques.

Le convertisseur continu-continu 5 n'ayant pas besoin d'être aussi rapide en termes de vitesse de commutation est donc plus simple à disposer et à mettre en oeuvre. Il permet d'atteindre de larges bandes passantes tout en respectant l'intégrité du signal à émettre.

L'invention porte également sur une antenne d'émission RF équipée du système de suivi de la puissance crête d'un signal de télécommunication à émettre pour une amplification de puissance RF 1 selon la présente invention ou mettant en oeuvre un procédé de calcul de valeur de crête et de sélection de tension d'alimentation selon la présente invention.

La présente invention peut par exemple trouver une application dans les stations de base pour la téléphonie mobile, dans les radars, dans les dispositifs de guerre électronique, dans les téléphones portables ou dans tout autre équipement sans fil de télécommunication.

## Revendications

1. - Système de suivi de la puissance crête d'un signal de télécommunication à émettre pour une amplification de puissance RF (1) dudit signal de télécommunication à émettre, comprenant :
- un amplificateur de puissance RF (2) ayant une entrée RF (2a), une entrée de tension d'alimentation (2b) et une sortie RF (2c),
- un dispositif de traitement numérique (3),
- un convertisseur numérique-RF (4), et
- un convertisseur continu-continu (5),
le dispositif de traitement numérique (3) ayant une entrée (3a) apte à recevoir le signal de télécommunication à émettre sous forme de données numériques, une première sortie (3b) reliée à une entrée du convertisseur numérique-RF (4) et une seconde sortie (3c) reliée à une entrée du convertisseur continu-continu (5), le convertisseur numérique-RF (4) ayant une sortie reliée à l'entrée RF (2a) de l'amplificateur de puissance RF (2), le convertisseur continu-continu (5) ayant une sortie reliée à l'entrée de tension d'alimentation (2b) de l'amplificateur de puissance RF (2), **caractérisé par le fait que** la sortie du convertisseur continu-continu (5) peut prendre une valeur de tension discrète parmi N valeurs de tension discrètes, N étant un nombre entier supérieur ou égal à 2, le dispositif de traitement numérique (3) comprenant entre son entrée (3a) et sa première sortie (3b), un élément de retard τ et entre son entrée (3a) et sa seconde sortie (3c) une chaîne de traitement (6) comprenant une logique de commande de suivi d'enveloppe (7) apte à créer un signal de commande de suivi d'enveloppe à N niveaux discrets (7a) à partir des données numériques reçues au niveau de l'entrée (3a) du dispositif de traitement numérique (3) , ledit signal de commande de suivi d'enveloppe à N niveaux discrets (7a) étant échantillonné à une fréquence d'échantillonnage prédéterminée, la chaîne de traitement (6) comprenant en outre, en aval de la logique de commande de suivi d'enveloppe (7), une logique de pilotage (8) du convertisseur continu-continu (5) comprenant un dispositif de calcul de valeur de crête (9) et un dispositif de sélection de tension d'alimentation (10) , le dispositif de calcul de valeur de crête (9) étant apte :
- à fenêtrer le signal de commande de suivi d'enveloppe à N niveaux discrets (7a), à l'aide d'une fenêtre temporelle glissante dont la durée est définie par un nombre prédéfini d'échantillons du signal de commande de suivi d'enveloppe à N niveaux discrets (7a), le décalage entre fenêtres temporelles étant égal à un échantillon du signal de commande de suivi d'enveloppe à N niveaux discrets (7a), et
- à calculer la valeur maximale (10a) du signal de commande de suivi d'enveloppe à N niveaux discrets (7a) sur chaque fenêtre temporelle de la fenêtre temporelle glissante,
et le dispositif de sélection de tension d'alimentation (10) étant apte à commander le convertisseur continu-continu (5) afin d'imposer à chaque instant à la sortie de ce dernier, parmi les N valeurs de tension discrètes, en fonction de la valeur maximale (10a) du signal de commande de suivi d'enveloppe à N niveaux discrets (7a) sur la fenêtre temporelle courante, de la valeur (10c) du signal de commande de suivi d'enveloppe à N niveaux discrets (7a) retardé de la durée de la fenêtre temporelle glissante et de la valeur courante (10b) de la sortie du dispositif de sélection de tension d'alimentation (10), une valeur de tension discrète d'alimentation supérieure ou égale au signal de commande de suivi d'enveloppe à N niveaux discrets (7a), ladite valeur de tension discrète d'alimentation étant appliquée pendant une durée minimale égale à la durée de la fenêtre temporelle glissante.

2. - Système (1) selon la revendication 1, **caractérisé par le fait que** l'élément de retard τ est choisi tel que le signal RF correspondant à des données numériques du signal de télécommunication à émettre au niveau de l'entrée RF (2a) de l'amplificateur de puissance RF (2) est synchronisé avec la tension d'alimentation de type suivi d'enveloppe du signal RF pour ces mêmes données numériques au niveau de l'entrée de tension d'alimentation (2b) de l'amplificateur de puissance RF (2).

3. - Système (1) selon la revendication 1 ou la revendication 2, **caractérisé par le fait que** le dispositif de sélection de tension d'alimentation (10) comprend un compteur temporel (11) configuré pour être réinitialisé et déclenché à chaque changement d'état de sortie du dispositif de sélection de tension d'alimentation (10), ledit dispositif de sélection de tension d'alimentation (10) étant configuré pour ne pas changer l'état de sa sortie tant que le compteur temporel (11) n'a pas atteint la durée de la fenêtre temporelle glissante.

4. - Système (1) selon la revendication 3, **caractérisé par le fait que** le dispositif de sélection de tension d'alimentation (10) comprend en outre un module de décision de changement d'état de sortie (12) configuré pour modifier l'état de la sortie du dispositif de sélection de tension d'alimentation (10), à la valeur maximale (10a) du signal de commande de suivi d'enveloppe à N niveaux discrets (7a) sur la fenêtre temporelle courante, lorsque le compteur temporel (11) a atteint la durée de la fenêtre temporelle glissante, et que la valeur maximale (10a) du signal de commande de suivi d'enveloppe à N niveaux discrets (7a) sur la fenêtre temporelle courante est inférieure à la valeur courante (10b) de la sortie du dispositif de sélection de tension d'alimentation (10) ou que la valeur courante (10b) de la sortie du dispositif de sélection de tension d'alimentation (10) est inférieure à la valeur (10c) du signal de commande de suivi d'enveloppe à N niveaux discrets (7a) retardé de la durée de la fenêtre temporelle glissante.

5. - Système (1) selon l'une des revendications 1 à 4, **caractérisé par le fait que** la logique de commande de suivi d'enveloppe (7) comprend un dispositif de calcul du module du signal de télécommunication à émettre et un dispositif de création de signal de commande de suivi d'enveloppe configuré pour créer le signal de commande de suivi d'enveloppe à N niveaux discrets (7a) par comparaison de la valeur du module calculé par ledit dispositif de calcul à (N-l) seuils de commutation prédéfinis.

6. - Système (1) selon l'une des revendications 1 à 5, **caractérisé par le fait que** le nombre de niveaux de tension N est compris entre 2 et 16.

7. - Système (1) selon l'une des revendications 1 à 6, **caractérisé par le fait que** le nombre prédéfini d'échantillons du signal de commande de suivi d'enveloppe à N niveaux discrets (7a) définissant la durée de la fenêtre temporelle glissante est compris entre 2 et 128.

8. - Système (1) selon l'une des revendications 1 à 7, **caractérisé par le fait que** le dispositif de traitement numérique (3) est mis en œuvre dans un circuit numérique programmable, de préférence un processeur, un microprocesseur, un microcontrôleur, un dispositif de traitement numérique de signal (DSP) , un circuit intégré spécifique à une application (ASIC) ou une matrice prédiffusée programmable (FPGA) .

9. - Système (1) selon l'une des revendications 1 à 8, **caractérisé par le fait que** le convertisseur continu-continu (5) est de type à multi-entrées d'alimentation en parallèle (13) ou de type à multi-entrées d'alimentation en cascade (14).

10. - Système (1) selon l'une des revendications 1 à 9, **caractérisé par le fait que** le convertisseur numérique-RF (4) comprend un convertisseur numérique analogique associé à un mélangeur RF.

11. - Système (1) selon l'une des revendications 1 à 10, **caractérisé par le fait que** le système (1) comprend en outre un filtre passe-bas disposé entre la sortie du convertisseur continu-continu (5) et l'entrée de tension d'alimentation (2b) de l'amplificateur de puissance RF (2).

12. - Système (1) selon l'une des revendications 1 à 11, **caractérisé par le fait que** le dispositif de traitement numérique (3) comprend en outre une logique de pré-distorsion qui linéarise le gain de l'amplificateur de puissance RF (2 .

13. - Procédé de calcul de valeur de crête et de sélection de tension d'alimentation mis en œuvre par un système de suivi de la puissance crête d'un signal de télécommunication à émettre pour une amplification de puissance RF (1) selon l'une des revendications 1 à 12, **caractérisé par le fait qu'**il comprend les étapes suivantes :
- le fenêtrage temporel, à l'aide d'une fenêtre temporelle glissante, d'un signal de commande de suivi d'enveloppe à N niveaux discrets (7a) ;
- le calcul de la valeur maximale (10a) du signal de commande de suivi d'enveloppe à N niveaux discrets (7a) sur chaque fenêtre temporelle de la fenêtre temporelle glissante ;
- la sélection, parmi N valeurs de tension discrètes, en fonction de la valeur maximale (10a) du signal de commande de suivi d'enveloppe à N niveaux discrets (7a) sur la fenêtre temporelle courante et de la valeur (10c) du signal de commande de suivi d'enveloppe à N niveaux discrets (7a) retardé de la durée de la fenêtre temporelle glissante, d'une valeur de tension discrète d'alimentation supérieure ou égale au signal de commande de suivi d'enveloppe à N niveaux discrets (7a), ladite valeur de tension discrète d'alimentation étant appliquée pendant une durée minimale égale à la durée de la fenêtre temporelle glissante ; et
- la commande d'un convertisseur continu-continu (5) afin d'imposer à chaque instant à la sortie de ce dernier la valeur de tension discrète d'alimentation sélectionnée.

14. - Antenne d'émission RF équipée d'un système de suivi de la puissance crête d'un signal de télécommunication à émettre pour une amplification de puissance RF (1) dudit signal de télécommunication à émettre selon l'une des revendications 1 à 12 ou mettant en œuvre un procédé de calcul de valeur de crête et de sélection de tension d'alimentation selon la revendication 13.

## Patentansprüche

1. - System zur Überwachung der Spitzenleistung eines Telekommunikationssignals, das für eine HF-Leistungsverstärkung (1) des zu sendenden Telekommunikationssignals zu senden ist, umfassend:
- einen HF-Leistungsverstärker (2) mit einem HF-Eingang (2a), einem Versorgungsspannungseingang (2b) und einem HF-Ausgang (2c),
- eine digitale Verarbeitungsvorrichtung (3),
- einen Digital-HF-Wandler (4), und
- einen DC-DC-Wandler (5),
wobei die digitale Verarbeitungsvorrichtung (3) einen Eingang (3a) hat, der imstande ist, das zu sendende Telekommunikationssignal in Form digitaler Daten zu empfangen, einen ersten Ausgang (3b), der mit einem Eingang des Digital-HF-Wandlers (4) verbunden ist und einen zweiten Ausgang (3c), der mit einem Eingang des DC-DC-Wandlers (5) verbunden ist, wobei der Digital-HF-Wandler (4) einen Ausgang hat, der mit dem HF-Eingang (2a) des HF-Leistungsverstärkers (2) verbunden ist, der DC-DC-Wandler (5) einen Ausgang hat, der mit dem Versorgungsspannungseingang (2b) des HF-Leistungsverstärkers (2) verbunden ist, **dadurch gekennzeichnet, dass** der Ausgang des DC-DC-Wandlers (5) einen diskreten Spannungswert von N diskreten Spannungswerten annehmen kann, wobei N eine Ganzzahl größer oder gleich 2 ist, wobei die digitale Verarbeitungsvorrichtung (3) zwischen ihrem Eingang (3a) und ihrem ersten Ausgang (3b) ein Verzögerungselement τ und zwischen ihrem Eingang (3a) und ihrem zweiten Ausgang (3c) eine Verarbeitungskette (6) umfasst, die eine Envelope Tracking-Steuerlogik (7) umfasst, die imstande ist, ein Envelope Tracking-Steuersignal mit N diskreten Niveaus (7a) ausgehend von den im Bereich des Eingangs (3a) der digitalen Verarbeitungsvorrichtung (3) empfangenen digitalen Daten zu erzeugen, wobei das Envelope Tracking-Steuersignal mit N diskreten Niveaus (7a) auf eine vorher festgelegten Samplingfrequenz gesampelt ist, wobei die Verarbeitungskette (6) ferner, der Envelope Tracking-Steuerlogik (7) nachgelagert, eine Steuerungslogik (8) des DC-DC-Wandlers (5) umfasst, die eine Spitzenwert-Berechnungsvorrichtung (9) und eine Versorgungsspannungs-Auswahlvorrichtung (10) umfasst, wobei die Spitzenwert-Berechnungsvorrichtung (9) imstande ist:
- das Envelope Tracking-Steuersignal mit N diskreten Niveaus (7a) mit Hilfe eines gleitenden Zeitfensters, dessen Dauer von einer vorher festgelegten Anzahl Samples des Envelope Tracking-Steuersignals mit N diskreten Niveaus (7a) definiert ist, zu fenstern, wobei die Abweichung zwischen den Zeitfenstern gleich einem Sample des Envelope Tracking-Steuersignals mit N diskreten Niveaus (7a) ist, und
- den maximalen Wert (10a) des Envelope Tracking-Steuersignals mit N diskreten Niveaus (7a) über jedes Zeitfenster des gleitenden Zeitfensters zu berechnen,
und die Versorgungsspannungs-Wahlvorrichtung (10) imstande ist, dem DC-DC-Wandler (5) zu befehlen, dem Ausgang desselben zu jedem Zeitpunkt von den N diskreten Spannungswerten in Abhängigkeit vom maximalen Wert (10a) des Envelope Tracking-Steuersignals mit N diskreten Niveaus (7a) im laufenden Zeitfenster, vom Wert (10c) des um die Dauer des gleitenden Zeitfensters verzögerten Envelope Tracking-Steuersignals mit N diskreten Niveaus (7a) und vom laufenden Wert (10b) des Ausgangs der Versorgungsspannungs-Wahlvorrichtung (10) einen diskreten Versorgungsspannungswert aufzuzwingen, der größer oder gleich dem Envelope Tracking-Steuersignal mit N diskreten Niveaus (7a) ist, wobei der diskrete Versorgungsspannungswert während einer minimalen Dauer angewendet wird, die gleich der Dauer des gleitenden Zeitfensters ist.

2. - System (1) nach Anspruch 1, **dadurch gekennzeichnet, dass** das Verzögerungselement τ derart gewählt ist, dass das HF-Signal, das digitalen Daten des zu sendenden Telekommunikationssignals im Bereich des HF-Eingangs (2a) des HF-Leistungsverstärkers (2) entspricht, mit der Versorgungsspannung vom Typ Envelope-Überwachung des HF-Signals für dieselben digitalen Daten im Bereich des Versorgungsspannungseingangs (2b) des HF-Leistungsverstärkers (2) synchronisiert wird.

3. - System (1) nach Anspruch 1 oder Anspruch 2, **dadurch gekennzeichnet, dass** die Versorgungsspannungs-Wahlvorrichtung (10) einen Zeitgeber (11) umfasst, der dazu ausgelegt ist, bei jeder Zustandsänderung des Ausgangs der Versorgungsspannungs-Wahlvorrichtung (10) reinitialisiert und ausgelöst zu werden, wobei die Versorgungsspannungs-Wahlvorrichtung (10) dazu ausgelegt ist, den Zustand ihres Ausgangs nicht zu ändern, solange der Zeitgeber (11) die Dauer des gleitenden Zeitfensters nicht erreicht hat.

4. - System (1) nach Anspruch 3, **dadurch gekennzeichnet, dass** die Versorgungsspannungs-Wahlvorrichtung (10) ferner ein Modul zur Entscheidung der Zustandsänderung des Ausgangs (12) umfasst, das dazu ausgelegt ist, den Zustand des Ausgangs der Versorgungsspannungs-Wahlvorrichtung (10) beim maximalen Wert (10a) des Envelope Tracking-Steuersignals mit N diskreten Niveaus (7a) über das laufende Zeitfenster zu ändern, wenn der Zeitgeber (11) die Dauer des gleitenden Zeitfensters erreicht hat, und wenn der maximale Wert (10a) des Envelope Tracking-Steuersignals mit N diskreten Niveaus (7a) über das laufende Zeitfenster kleiner als der laufende Wert (10b) des Ausgangs der Versorgungsspannungs-Wahlvorrichtung (10) ist oder wenn der laufende Wert (10b) des Ausgangs der Versorgungsspannungs-Wahlvorrichtung (10) kleiner als der Wert (10c) des um die Dauer des gleitenden Zeitfensters verzögerten Envelope Tracking-Steuersignals mit N diskreten Niveaus (7a) ist.

5. - System (1) nach einem der Ansprüche 1 bis 4, **dadurch gekennzeichnet, dass** die Envelope Tracking-Steuerlogik (7) eine Berechnungsvorrichtung des Moduls des zu sendenden Telekommunikationssignals und eine Vorrichtung zur Erzeugung des Envelope Tracking-Steuersignals umfasst, die dazu ausgelegt ist, das Envelope Tracking-Steuersignal mit N diskreten Niveaus (7a) durch Vergleich des Werts des von der Berechnungsvorrichtung berechneten Moduls mit (N-1) vorher festgelegten Umschaltgrenzwerten zu erzeugen.

6. - System (1) nach einem der Ansprüche 1 bis 5, **dadurch gekennzeichnet, dass** die Anzahl der Spannungsniveaus N zwischen 2 und 16 liegt.

7. - System (1) nach einem der Ansprüche 1 bis 6, **dadurch gekennzeichnet, dass** die vorher festgelegte Anzahl von Samples des Envelope Tracking-Steuersignals mit N diskreten Niveaus (7a), die die Dauer des gleitenden Zeitfensters bestimmen, zwischen 2 und 128 liegt.

8. - System (1) nach einem der Ansprüche 1 bis 7, **dadurch gekennzeichnet, dass** die digitale Verarbeitungsvorrichtung (3) in einem programmierbaren digitalen Schaltkreis, vorzugsweise einem Prozessor, einem Mikroprozessor, einem Mikrocontroller, einer digitalen Signalverarbeitungsvorrichtung (DSP), einem anwendungsspezifischen integrierten Schaltkreis (ASIC) oder einem Field Programmable Gate Array (FPGA) umgesetzt wird.

9. - System (1) nach einem der Ansprüche 1 bis 8, **dadurch gekennzeichnet, dass** der DC-DC-Wandler (5) vom Typ mit mehreren parallelen Versorgungseingängen (13) oder vom Typ mit mehreren kaskadierten Versorgungseingängen (14) ist.

10. - System (1) nach einem der Ansprüche 1 bis 9, **dadurch gekennzeichnet, dass** der Digital-HF-Wandler (4) einen Digital-Analog-Wandler umfasst, der einem HF-Mischer zugeordnet ist.

11. - System (1) nach einem der Ansprüche 1 bis 10, **dadurch gekennzeichnet, dass** das System (1) ferner einen Tiefpassfilter umfasst, der zwischen dem Ausgang des DC-DC-Wandlers (5) und dem Versorgungsspannungseingang (2b) des HF-Leistungsverstärkers (2) angeordnet ist.

12. - System (1) nach einem der Ansprüche 1 bis 11, **dadurch gekennzeichnet, dass** die digitale Verarbeitungsvorrichtung (3) ferner eine Vorverzerrungslogik umfasst, die den Gain des HF-Leistungsverstärkers (2) linearisiert.

13. - Verfahren zur Berechnung des Spitzenwerts und der Auswahl einer Versorgungsspannung, das von einem System zur Überwachung der Spitzenleistung eines für eine HF-Leistungsverstärkung (1) zu sendenden Telekommunikationssignals nach einem der Ansprüche 1 bis 12 durchgeführt wird, **dadurch gekennzeichnet, dass** es die folgenden Schritte umfasst:
- das zeitliche Fenstern mit Hilfe eines gleitenden Zeitfensters eines Envelope Tracking-Steuersignals mit N diskreten Niveaus (7a);
- das Berechnen des maximalen Werts (10a) des Envelope Tracking-Steuersignals mit N diskreten Niveaus (7a) über jedes Zeitfenster des gleitenden Zeitfensters;
- das Auswählen aus N diskreten Spannungswerten in Abhängigkeit vom maximalen Wert (10a) des Envelope Tracking-Steuersignals mit N diskreten Niveaus (7a) über das laufende Zeitfenster und vom Wert (10c) des um die Dauer des gleitenden Zeitfensters verzögerten Envelope Tracking-Steuersignals mit N diskreten Niveaus (7a) eines diskreten Versorgungsspannungswerts, der größer oder gleich dem Envelope Tracking-Steuersignal mit N diskreten Niveaus (7a) ist, wobei der diskrete Versorgungsspannungswert während einer minimalen Dauer angewendet wird, die gleich der Dauer des gleitenden Zeitfensters ist; und
- das Steuern eines DC-DC-Wandlers (5), dem Ausgang desselben zu jedem Zeitpunkt den ausgewählten diskreten Versorgungsspannungswert aufzuzwingen.

14. - HF-Sendeantenne, die mit einem System zu Überwachung der Spitzenleistung eines zu sendenden Telekommunikationssignals für eine HF-Leistungsverstärkung (1) des zu sendenden Telekommunikationssignals nach einem der Ansprüche 1 bis 12 ausgestattet ist oder ein Verfahren zur Berechnung des Spitzenwerts und der Wahl der Versorgungsspannung nach Anspruch 13 durchführt.

## Claims

1. - A system (1) for tracking the peak power of a telecommunication signal to be transmitted for an RF power amplification of said telecommunication signal to be transmitted, comprising:
- an RF power amplifier (2) having an RF input (2a), a supply voltage input (2b) and an RF output (2c),
- a digital processing device (3),
- a digital to RF converter (4), and
- a DC-DC converter (5),
the digital processing device (3) having an input (3a) capable of receiving the telecommunication signal to be transmitted in the form of digital data, a first output (3b) connected to an input of the digital to RF converter (4) and a second output (3c) connected to an input of the DC-DC converter (5), the digital to RF converter (4) having an output connected to the RF input (2a) of the RF power amplifier (2), the DC-DC converter (5) having an output connected to the supply voltage input (2b) of the RF power amplifier (2), **characterized in that** the output of the DC-DC converter (5) is able to assume a discrete voltage value from among N discrete voltage values, N being an integer greater than or equal to 2, the digital processing device (3) comprising, between its input (3a) and its first output (3b), a delay element τ, and between its input (3a) and its second output (3c), a processing chain (6) comprising an envelope tracking control logic (7) capable of creating an envelope tracking control signal with N discrete levels (7a) from digital data received at the input (3a) of the digital processing device (3), said envelope tracking control signal with N discrete levels (7a) being sampled at a predetermined sampling frequency, the processing chain (6) further comprising, downstream from the envelope tracking control logic (7), a driver logic (8) of the DC-DC converter (5) comprising a device for calculating the peak value (9) and a device for selecting the supply voltage (10), the device for calculating the peak value (9) being capable of:
- windowing the envelope tracking control signal with N discrete levels (7a), using a sliding time window, the duration of which is defined by a predefined number of samples of the envelope tracking control signal with N discrete levels (7a), the offset between time windows being equal to a sample of the envelope tracking control signal with N discrete levels (7a), and
- calculating the maximum value (10a) of the envelope tracking control signal with N discrete levels (7a) over each time window of the sliding time window,
and the supply voltage selection device (10) being capable of controlling the DC-DC converter (5) in order to impose at all times, on the output of the latter, from among the N discrete voltage values, as a function of the maximum value (10a) of the envelope tracking control signal with N discrete levels (7a) over the current time window, of the value (10c) of the envelope tracking control signal with N discrete levels (7a) delayed by the duration of the sliding time window and of the current value (10b) of the output of the device for selecting the supply voltage (10), a discrete supply voltage value greater than or equal to the envelope tracking control signal with N discrete levels (7a), said discrete supply voltage value being applied during a minimum duration equal to the duration of the sliding time window.

2. - The system (1) according to claim 1, **characterized in that** the delay element τ is chosen such that the RF signal corresponding to digital data of the telecommunication signal to be transmitted at the RF input (2a) of the RF power amplifier (2) is synchronized with the supply voltage of the envelope tracking type of the RF signal for said same digital data at the supply voltage input (2b) of the RF power amplifier (2).

3. - The system (1) according to claim 1 or claim 2, **characterized in that** the device for selecting the supply voltage (10) comprises a time counter (11) configured to be reset and triggered upon each change of output state of the device for selecting the supply voltage (10), said device for selecting the supply voltage (10) being configured not to change the state of its output as long as the time counter (11) has not reached the duration of the sliding time window.

4. - The system (1) according to claim 3, **characterized in that** the device for selecting the supply voltage (10) further comprises an output state changing decision module (12) configured to modify the output state of the device for selecting the supply voltage (10), to the maximum value (10a) of the envelope tracking control signal with N discrete levels (7a) over the current time window, when the time counter (11) has reached the duration of the sliding time window, and the maximum value (10a) of the envelope tracking control signal with N discrete levels (7a) over the current time window is less than the current value (10b) of the output of the device for selecting the supply voltage (10) or the current value (10b) of the output of the device for selecting the supply voltage (10) is less than the value (10c) of the envelope tracking control signal with N discrete levels (7a) delayed by the duration of the sliding time window.

5. - The system (1) according to one of claims 1 to 4, **characterized in that** the envelope tracking control logic (7) comprises a device for calculating the modulus of the telecommunication signal to be transmitted and a device for creating the envelope tracking control signal configured to create the envelope tracking control signal with N discrete levels (7a) by comparing the value of the modulus calculated by said calculating device with (N-1) predefined switching thresholds.

6. - The system (1) according to one of claims 1 to 5, **characterized in that** the number of voltage levels N is between 2 and 16.

7. - The system (1) according to one of claims 1 to 6, **characterized in that** the predefined number of samples of the envelope tracking control signal with N discrete levels (7a) defining the duration of the sliding time window is between 2 and 128.

8. - The system (1) according to one of claims 1 to 7, **characterized in that** the digital processing device (3) is implemented in a programmable digital circuit, preferably a processor, a microprocessor, a microcontroller, a digital signal processing (DSP) device, an application-specific integrated circuit (ASIC) or a field-programmable gate array (FPGA).

9. - The system (1) according to one of claims 1 to 8, **characterized in that** the DC-DC converter (5) is of the type with multiple supply inputs in parallel (13) or of the type multiple supply inputs in cascade (14).

10. - The system (1) according to one of claims 1 to 9, **characterized in that** the digital to RF converter (4) comprises a digital to analog converter associated with an RF mixer.

11. - The system (1) according to one of claims 1 to 10, **characterized in that** the system (1) further comprises a low-pass filter arranged between the output of the DC-DC converter (5) and the supply voltage input (2b) of the RF power amplifier (2).

12. - The system (1) according to one of claims 1 to 11, **characterized in that** the digital processing device (3) further comprises a predistortion logic that linearizes the gain of the RF power amplifier (2).

13. - A method for calculating the peak value and selecting the supply voltage implemented by a system (1) for tracking the peak power of a telecommunication signal to be transmitted for an RF power amplification according to one of claims 1 to 12, **characterized in that** it comprises the following steps:
- time windowing, using a sliding time window, of an envelope tracking control signal with N discrete levels (7a) ;
- calculating the maximum value (10a) of the envelope tracking control signal with N discrete levels (7a) over each time window of the sliding time window;
- selecting, from among N discrete voltage values, based on the maximum value (10a) of the envelope tracking control signal with N discrete levels (7a) over the current time window and on the value (10c) of the envelope tracking control signal with N discrete levels (7a) delayed of the duration of the sliding time window, a discrete supply voltage value greater than or equal to the envelope tracking control signal with N discrete levels (7a), said discrete supply voltage value being applied during a minimum duration equal to the duration of the sliding time window; and
- controlling a DC-DC converter (5) in order to impose at all times, on the output of the latter, the selected discrete supply voltage value.

14. - An RF transmission antenna equipped with a system (1) for tracking the peak power of a telecommunications signal to be transmitted for an RF power amplification (1) of said telecommunication signal to be transmitted according to one of claims 1 to 12 or implementing a method for calculating the peak value and selecting the supply voltage according to claim 13.
